Europäisches Patentamt

European Patent Office

Office européen des brevets

(19)

(11) Veröffentlichungsnummer: **0 079 602**
**B1**

(12) # EUROPÄISCHE PATENTSCHRIFT

(45) Veröffentlichungstag der Patentschrift:
18.03.87

(21) Anmeldenummer: 82110495.7

(22) Anmeldetag: 13.11.82

(51) Int. Cl.⁴: **H 01 F 17/00**, H 05 K 3/20

(54) Verfahren zur Herstellung gedruckter Leiterbahnen.

(30) Priorität: 17.11.81 DE 3145585

(43) Veröffentlichungstag der Anmeldung:
25.05.83 Patentblatt 83/21

(45) Bekanntmachung des Hinweises auf die Patenterteilung:
18.03.87 Patentblatt 87/12

(84) Benannte Vertragsstaaten:
DE FR GB IT NL

(56) Entgegenhaltungen:
DE-B-1 521 441
FR-A-1 512 035
FR-A-1 566 978
GB-A-828 291
US-A-3 431 350

(73) Patentinhaber: ROBERT BOSCH GMBH, Postfach
50, D-7000 Stuttgart 1 (DE)

(72) Erfinder: Grünwald, Werner, Dr., Robert-
Schumann- Strasse 21, D-7016 Gerlingen (DE)
Erfinder: Pfizenmaier, Heinz, Liststrasse 6, D-7250
Leonberg (DE)
Erfinder: de la Prieta, Claudio,
Schwarzwaldstrasse 81, D-7000 Stuttgart 80 (DE)
Erfinder: Schmid, Kurt, Schlossstrasse 55, D-7257
Ditzingen 4 (DE)
Erfinder: Schmidt, Ewald, Bachstrasse 10, D-7140
Ludwigsburg (DE)

## Beschreibung

### Stand der Technik

Die Erfindung geht aus von einem Verfahren nach der Gattung der Ansprüche 1 oder 2. Bekannte Verfahren zur Herstellung von Flächenmustern arbeiten mit Aufrollverfahren oder Aufstreichverfahren. Weiterhin sind Siebdruckverfahren bekannt zum Aufbringen von elektrisch leitfähigen Mustern. Aus der DE-OS 30 14 877 ist ferner ein Verfahren zum Auftragen einer Abgas-Sauerstoff-Sensorelektrode (Lambda-Sonde) bekannt, bei der eine elektrisch leitfähige Flüssigkeit oder Paste dosiert in einen Hohlkörper eingebracht und mittels eines aufblähbaren, fingerartigen Teiles in dem Hohlkörper verteilt wird. Schließlich sind elektrisch leitfähige Pasten der interessierenden Art beispielsweise bekannt aus der DE-OS 29 13 633 und/oder aus der DE-OS 30 02 112. Die bekannten Verfahren sind teilweise fertigungstechnisch sehr aufwendig, andererseits eignen sie sich nur bedingt für teure leitfähige Pasten mit hohem Edelmetallgehalt, da sie nur schwer eine Minimierung der aufgetragenen Pastenmenge gestatten.

In der FR-PS 1 566 978 ist ein Verfahren zum Drucken elektrischer Schaltungen auf Substraten angegeben. Dieses Verfahren ist als Tampoprint-Verfahren bekannt, wobei man gegen die Oberfläche einer Intaglio-Druckplatte eine elastische Übertragungsvorrichtung preßt und das von dieser aufgenommene Material auf das Substrat überträgt. Nach der FR-PS 1 566 978 werden nur ebene Flächen mit einem Muster bedruckt.

In der FR-PS 1 512 035 wird ein Verfahren zur Herstellung einer Induktivität beschrieben. Auf ein Substrat wird ein leitfähiges Muster gedruckt, welches ein Teil der Wicklung darstellt. Auf dieses Muster wird magnetisches Material aufgebracht. Dieses Verfahren ist auf Dicken des magnetischen Materials von einigen 10 μm beschränkt. Im letzten Verfahrensschritt wird auf das magnetisierbare Material ein elektrisch leitfähiges Muster in der Weise aufgedruckt, daß eine Verbindung zu dem auf dem Substrat aufgedruckten Muster gegeben ist, damit eine geschlossene Wicklung entsteht.

### Vorteile der Erfindung

Durch das erfindungsgemäße Verfahren mit den kennzeichnenden Merkmalen der Ansprüche 1 und 2 erreicht man bei der Fertigung von Induktivitäten eine beträchtliche Verringerung des Fertigungsaufwandes, weil derartige Induktivitäten bislang üblicherweise entweder mit Drähten gewickelt oder durch Aufbringen vorgefertigter Wicklungen aus Draht hergestellt wurden. Neben der Verringerung des Fertigungsaufwandes ergibt sich jedoch auch eine erhebliche Platzersparnis gegenüber bekannten Induktivitäten, was sich besonders vorteilhaft bemerkbar macht beim Einbau in sogenannte Hybridschaltungen, wo neben gedruckten und integrierten Schaltelementen auch diskrete Bauelemente verwendet werden. Durch die exakte Dosierbarkeit der aufzutragenden Paste können erhebliche Kosten eingespart werden durch die Einsparung teurer Edelmetalle. Die nach dem erfindungsgemäßen Verfahren hergestellten Induktivitäten weisen geringe Streufelder auf und besitzen kleine parasitäre Kapazitäten. Weiterhin bringt die exakte Dosierung und die exakte Einhaltung vorgegebener Geometrien durch Abnahme der Paste von Druck-Klischees wesentlich bessere Verfahrensergebnisse zustande. Je nach herzustellenden Muster kann es entweder vorteilhaft sein mit translatorischen oder rotatorischen Bewegungen des Druckstempels zu arbeiten, wobei für besondere Anwendungen eine rotatorische Bewegung auch durch mehrere nacheinander ausgeführte translatorische Bewegungen ersetzt werden kann; letzteres gilt insbesondere für die exakte Positionierung des Auftrages, beispielsweise, wenn bereits vorhandene Leiterbahnen in einem weiteren Druckvorgang verlängert oder in sich geschlossen werden sollen.

### Zeichnung

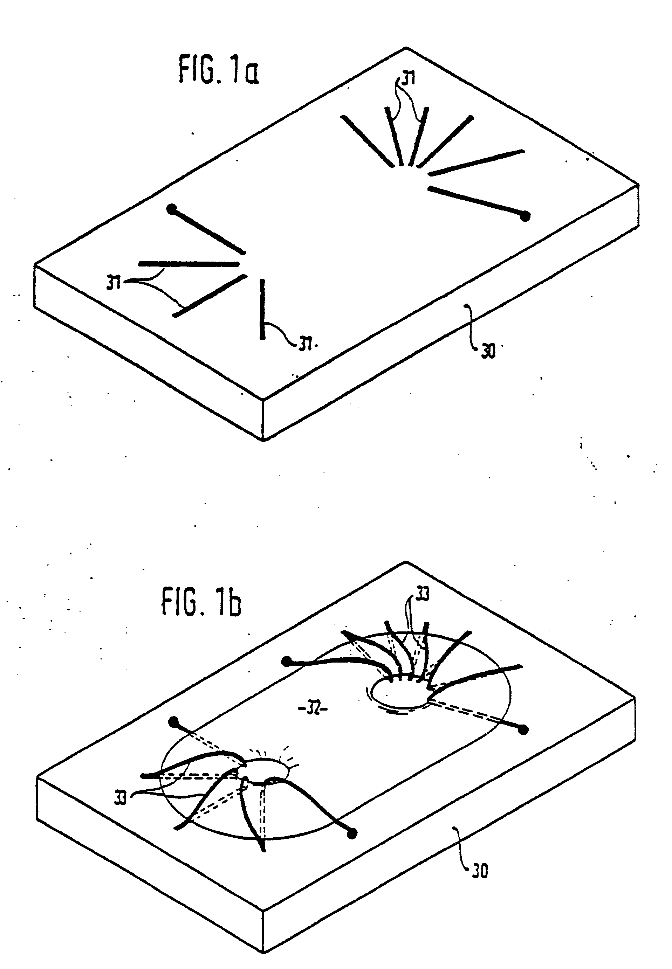

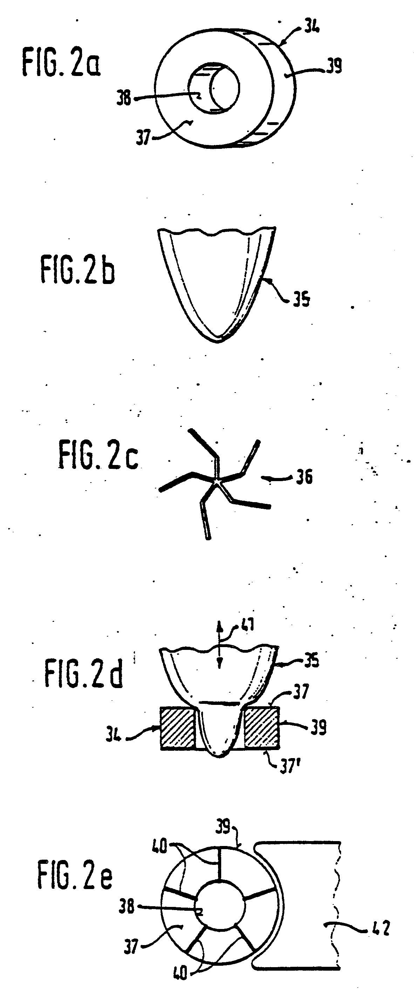

Ausführungsbeispiele der Erfindung sind anhand besonders vorteilhafter Verwendungen in den Zeichnungen schematisch dargestellt und in der nachfolgenden Beschreibung näher erläutert. Es zeigen Figur 1 das Drucken der Leiterbahnen einer Induktivität auf einem Substrat und Figur 2 das Drucken der Leiterbahnen einer allseitig freiliegenden Wicklung einer Induktivität.

### Beschreibung der Ausführungsbeispiele

Figur 1 zeigt eine Anordnung, bei der das Druckverfahren mit einem elastisch verformbaren Druckstempel, vorzugsweise am Silikongummi, zum Aufdruck einer elektrisch leitfähigen Paste verwendet ist zur Herstellung einer Induktivität, welche sich insbesondere eignet zum Einbau in Hybrid-Schaltkreise. In Figur 1a ist mit 30 ein elektrisch isolierendes, ebenes Substrat bezeichnet, auf das zunächst untere Leiterbahnen 31 in einem ersten Verfahrensschritt aufgedruckt worden sind. Nach diesem ersten Arbeitsgang entsprechend Figur 1a, bei dem eine Seite der Windungen entsteht, wird in einem zweiten Arbeitsgang entsprechend Figir 1b die andere Seite der Windungen auf einen Ferritkern 32 und die freiliegenden Enden der Leiterbahnen 31 aufgedruckt. Die oberen Leiterbahnen sind mit 33 bezeichnet und derart angeordnet, daß durch die Kontaktierung im Überdruckungsbereich mit den unteren Leiterbahnen 31 die Windungen der Induktivität entstehen. Der Ferritkern 32 ist auf das Substrat 30 aufgeklebt und hierdurch dauerhaft positioniert. Die so hergestellte Chip-Induktivität läßt sich sehr einfach und platzsparend in Hybridschaltungen integrieren.

Figur 2 zeigt in schematischer Darstellung ein anderes Verfahren, welches sich in besonders vorteilhafter Weise zur Herstellung kleiner Induktivitäten eignet. Figur 2a zeigt einen Ferritkern 34, welcher in seiner Bohrung und auf seinen Stirnflächen mittels eines spitz zulaufenden Stempels 35 aus Silikongummi bedruckt wird.

Der Stempel 35 ist schematisch in Figur 2b angedeutet. Figur 2c zeigt ein Muster 36 zum Aufdrucken der Leiterbahnen auf die Stirnseiten 37 und in die Bohrung 38 des Ferritkerns 34. Dieses Ätzmuster entspricht dem Klischeemuster, welches durch den Druckstempel auf das zu bedruckende Teil übertragen wird. Figur 2d zeigt schematisch den teilweise bereits verformten Stempel 35 nach dem Einführen entsprechend Pfeil 41 in die Bohrung 38. Auf diese Weise wird die Bohrung 38 etwa zur Hälfte sowie eine Stirnseite 37 des Ferritkerns 34 mit den Leiterbahnen der Induktivität bedruckt, bevor in einem weiteren Arbeitsgang der gleichen Art dieser Druckvorgang spiegelbildlich von der anderen Stirnseite 37' des Ferritkerns 34 wiederholt wird. In einem letzten Druckvorgang wird schließlich auf den Mantel 39 des Ferritkerns 34 ein weiterer Teil der Leiterbahnen 40 aufgedruckt, wodurch sich die fertige Wicklung der Induktivität ergibt. Das Bedrucken des Mantels 39 erfolgt beim Ausführungsbeispiel gemäß Figur 2e in drei Schritten durch translatorische Druckbewegungen eines Stempels 42 senkrecht zum Mantel 39 des Ferritkerns 34. Als metallischer Bestandteil zur Herstellung der Leiterbahnen 40 auf einem Ferritkern entsprechend Figur 2 wird vorzugsweise Silber benutzt. Anstelle einer translatorischen Druckbewegung entlang des Mantels 39 kann jedoch auch ein rotierender Druckstempel nach entsprechender Ausgangspositionierung benutzt werden.

Die Anordnungen entsprechend den Figuren 1 und 2 beinhalten wesentliche fertigungstechnische Verbesserungen gegenüber herkömmlichen Verfahren und führen zu einer Induktivität mit hohem Gebrauchswert, da einerseits das aufwendige Durchziehen einzelner Drahtwindungen oder das Verarbeiten vorgefertigter Wicklungen entfällt und andererseits einfach in vorhandene Hybridschaltungen zu integrierende Anordnungen mit geringen parasitären Kapazitäten entstehen. Durch das verwendete Verfahren entstehen präzise gestaltete und dimensionierte Dickschicht-Muster. Durch die Verformbarkeit des Druckstempels können gekrümmte Oberflächen mit der leitfähigen Paste belegt werden, wobei keine Verzerrungen des Drucks auftreten, da die Deformierung des Druckstempels bei der Gestaltung des Klischees berücksichtigt wird. Als Druckpaste können z.B. die in den eingangs genannten Druckschriften beschriebenen Pasten verwendet werden.

## Patentansprüche

1. Verfahren zum Aufdrucken einer elektrischen Wicklung aus einer elektrisch leitfähigen Paste auf vorgegebenen Bereichen eines magnetisierbaren Materials zur Herstellung einer Induktivität, wobei in einem ersten Arbeitsgang eine Seite der Wicklung (31) auf einen ebenen, elektrisch isolierenden Träger (30) und in einem zweiten Arbeitsgang die andere Seite (33) der Wicklung auf das auf den Träger nach dem ersten Arbeitsgang aufgebrachte magnetisierbare Material (32) derart aufgedruckt wird, daß geschlossene Windungen entstehen, dadurch gekennzeichnet, daß auf den Träger (30) nach dem Aufdrucken der einen Seite (31) der Wicklung (31, 33) ein Ferritkern (32) als diskretes Bauelement eines Hybridschaltkreises aufgeklebt und die andere Seite (33) der Wicklung mittels eines elastisch verformbaren Stempels auf den Ferritkern (32) aufgedruckt wird.

2. Verfahren zur Herstellung elektrisch leitfähiger Muster aus einer elektrisch leitfähigen Paste auf vorgegebenen Bereichen eines Ferritkerns (34) zur Herstellung einer Induktivität, insbesondere für Hybridschaltkreise, dadurch gekennzeichnet, daß mittels eines elastisch verformbaren Stempels (35) in einem ersten Arbeitsgang einseitig die Bohrung und eine Stirnfläche (37) eines Ferritkernes (34) mit Leiterbahnen (40) bedruckt werden, daß in einem zweiten Arbeitsgang dieser Druckvorgang spiegelbildlich von der anderen Stirnseite (37') des Ferritkernes (34) wiederholt wird und daß in einem weiteren, vorzugsweise nachgeschalteten Druckvorgang die Leiterbahnen (40) auf dem Mantel (31) des Ferritkernes (34) zu fortlaufenden Windungen geschlossen werden.

## Claims

1. Method for printing an electrical winding consisting of an electrically conducting paste on specified regions of a magnetizable material to produce an inductor, in which process, in a first operation, one side of the winding (31) is printed on a flat, electrically insulating carrier (30) and, in a second operation, the other side (33) of the winding is printed on the magnetizable material (32) mounted on the carrier after the first operation in a manner such that closed windings are produced, characterized in that a ferrite core (32) is bonded as a discrete component of a hybrid circuit onto the carrier (30) after the printing thereon of one side (32) of the winding (37,33) and the other side (33) of the winding is printed by means of an elastically deformable stamp on the ferrite core (32).

2. Method for producing electrically conducting patterns from an electrically conducting paste on specified regions of a ferrite core (32) to produce an inductor in particular for hybrid circuits, characterized in that in a first operation, the hole and an end face (37) of surface a ferrite core (34) are printed with conductor tracks (40) on one side, by means of an electrically defamable stamp that, in a second operation, this printing operation is repeated in a mirror-image fashion from the other end face (37') and that in a further, preferably later printing operation, the conductor tracks (40) on the outside (31) of the ferrite core (34) are closed to form continuous windings.

## Revendications

1°) Procédé pour imprimer un enroulement électrique à partir d'une pâte conductrice de l'électricité sur des zones prescrites d'une matière magnétisable, pour la fabrication d'une inductance, où, dans une première opération, une face de l'enroulement (31) est imprimée sur un support (30), plan, isolant de l'électricité, et dans une seconde opération, l'autre face (33) de l'enroulement sur la matière (32) magnétisable appliquée sur le support après la première opération, de façon telle qu'il se forme des spires fermées, procédé caractérisé en ce que, sur le support (30), on colle, après avoir imprimé une des faces (31) de l'enroulement (31, 33), un noyau en ferrite (32) comme composant séparé d'un circuit de commutation hybride, et imprime l'autre face (33) de l'enroulement, sur le noyau en ferrite (32), au moyen d'un tampon déformable élastiquement.

2°) Procédé pour la fabrication d'un dessin conducteur de l'électricité, à partir d'une pâte conductrice de l'électricité sur des zones données d'un noyau en ferrite (34), pour la fabrication d'une inductance, en particulier, pour des circuits de commutation hybrides, procédé caractérisé en ce qu'au moyen d'un tampon (35) déformable élastiquement, dans une première opération, on imprime une face, la perforation et une surface frontale (37) d'un noyau en ferrite (34), avec des conducteurs (40), que, dans une seconde opération, on renouvelle symétriquement, cette operation sur l'autre face frontale (37') du noyau en ferrite (34), et que, dans une autre opération d'impression, qui, de préférence, suit immédiatement, on ferme les conducteurs (40) sur l'enveloppe (31) du noyau en ferrite (34) en spires fermées.

# FIG. 1a

# FIG. 1b

FIG.2a

FIG.2b

FIG.2c

FIG.2d

FIG.2e